# FASCICULE DE BREVET EUROPEEN

(11) **EP 3 319 117 B1**
(45) Date de publication et mention de la délivrance du brevet: **04.08.2021**
(21) Numéro de dépôt: 17199696.0
(22) Date de dépôt: 02.11.2017
(51) Int. Cl.: H01L 21/67, H01L 21/673

(54) **DISPOSITIF POUR LE MAINTIEN DE PLAQUES COMPORTANT CHACUNE UN MATÉRIAU SEMI-CONDUCTEUR**
HALTEVORRICHTUNG FÜR HALBLEITERSCHEIBEN
HOLDING DEVICE FOR SEMICONDUCTOR WAFERS

(30) Priorité: 08.11.2016 FR 1660773
(43) Date de publication de la demande: 09.05.2018
(73) Titulaire: COMMISSARIAT À L'ÉNERGIE ATOMIQUE ET AUX ÉNERGIES ALTERNATIVES, 75015 Paris (FR)
(72) Inventeur: PICARD, Erwann, 73000 CHAMBERY (FR); LIGNIER, Hélène, 38380 SAINT LAURENT DU PONT (FR)
(74) Mandataire: Dumont, Alban

(56) Documents cités:
- WO-A1-2014/191624
- US-A- 4 593 644

## Description

### Domaine de l'invention

Le domaine de l'invention concerne le domaine de l'électronique, et plus particulièrement le maintien de plaques comportant chacune un matériau semi-conducteur au cours d'une ou plusieurs étapes technologiques de fonctionnalisation des plaques.

### Etat de la technique

Par exemple, dans le domaine de la réalisation des cellules photovoltaïques, il est commun d'utiliser des plaques de semi-conducteur (aussi connues sous la dénomination plaquette, ou « wafer » en anglais) par exemple en silicium cristallin. Pour former la cellule photovoltaïque en utilisant cette plaque, cela nécessite généralement une étape de diffusion de dopants sur l'une des faces de la plaque en vue de former une jonction pn qui générera l'effet photovoltaïque. Cette diffusion superficielle d'atomes par exemple de phosphore (P) dans le cas d'un matériau de type p, ou par exemple de bore (B) dans le cas d'un matériau de type n, ne doit s'effectuer que sur une seule face dans le cas d'architectures standards de cellules photovoltaïques. En général, il est utilisé des étapes technologiques supplémentaires afin d'isoler électriquement la face avant de la face arrière de la cellule. Ces étapes supplémentaires sont souvent coûteuses et/ou amoindrissent les performances de la cellule. Par exemple, il est possible d'utiliser une irradiation laser sur le périmètre de la plaquette (peu coûteuse mais qui réduit les performances des cellules photovoltaïques), ou bien une étape d'isolation par voie chimique appelée communément en langue anglaise "Single Side Etching" et utilisant par exemple des bains de HF:HNO3 puis du KOH puis du HF:HCl pour retirer le dépôt non souhaité sur l'une des faces, mais qui se révèle très coûteuse au niveau industriel. Alternativement, il est aussi connu de réaliser une étape de masquage réalisée en amont de la diffusion de dopant pour que cette diffusion ne s'effectue que sur une seule face de la plaque. Cette dernière solution de masque n'est pas satisfaisante car d'une part le coût de fabrication est affecté par une étape supplémentaire, et d'autre part elle pose de nombreux problèmes de contaminations, notamment lorsque la diffusion du dopant se déroule à haute température : dans ce cas il est délicat de garantir un environnement inerte qui permettrait d'éviter ces contaminations préjudiciables dans la suite du procédé de fabrication des cellules photovoltaïques.

La principale solution utilisée dans l'industrie consiste à placer les plaques de silicium dans une enceinte d'où il résulte le dopage de leurs deux faces. Ensuite, une des faces de chaque plaque (appelée face arrière) est attaquée chimiquement pour retirer le dopage à la manière du « Single Side Etching » décrit ci-dessus en réalisant successivement un bain de HF (HF correspondant à de l'acide fluorhydrique) pour retirer l'oxyde en face arrière, un bain de rinçage, un bain de HF:HNO3 (HNO3 correspondant à de l'acide nitrique) pour réaliser une gravure du silicium en face arrière, un bain de rinçage, un bain de KOH (KOH correspondant à de l'hydroxyde de potassium) pour graver du silicium poreux généré par la gravure du bain HF:HNO3, un bain de rinçage, un bain de HF:HCL (HCL correspondant à de l'acide chlorhydrique) pour retirer l'oxyde et nettoyer les contaminants K générés par le KOH, un dernier bain de rinçage puis un séchage. En raison de la forte consommation d'eau et de produits chimiques ce procédé est coûteux. « : » entre deux composés signifie que ces composés sont mélangés dans une même solution.

Le document WO2009/090504 décrit une nacelle de support dans laquelle des plaques sont maintenues ponctuellement par des encoches. Des pièges à gaz sont formés pour piéger les constituants très réactifs de gaz précurseur pour favoriser un dépôt homogène sur une face des plaques. Il en reste néanmoins que cette solution n'empêche pas le dépôt sur les deux faces de chaque plaque.

Il est aussi connu d'utiliser des nacelles où l'on met deux plaques par encoches, cependant cette solution provoque un dopage partiel entre les deux plaques placées dans la même encoche ce qui n'est pas satisfaisant.

Ces solutions ne sont pas satisfaisantes, et il existe un besoin de développer une solution plus simple à mettre en œuvre et permettant de diminuer les coûts liés à la production de plaques par exemple dopées électriquement, en particulier pour le domaine photovoltaïque.
Le brevet US4,593,644 décrit un dispositif pour le transport de substrats configuré pour tenir une pluralité de paires de substrats en position verticale de sorte que des gaz puissent passer entre des faces principales opposées des substrats.

### Objet de l'invention

L'invention a pour but un dispositif pour le maintien de plaques permettant de réaliser un traitement simultané au niveau, ou du côté, d'une seule face de plusieurs plaques.

On tend vers ce but grâce à un dispositif pour le maintien de plaques comportant chacune un matériau semi-conducteur et présentant chacune des première et deuxième faces, ledit dispositif comportant un premier organe et un deuxième organe, ce dispositif étant caractérisé en ce qu'il comporte, dans une configuration d'assemblage du dispositif :
- le premier organe assemblé au deuxième organe de sorte à délimiter une pluralité de cadres de maintien définissant chacun un emplacement destiné à la réception d'un couple de plaques à maintenir, dont les premières faces sont orientées l'une vers l'autre, chaque cadre de maintien étant adjacent à au moins un autre cadre de maintien,
- pour chaque couple de cadres de maintien adjacents, un passage reliant, entre lesdits cadres de maintien adjacents, l'extérieur du dispositif à un espace séparant les emplacements définis par lesdits cadres de maintien adjacents.

Notamment, chaque cadre de maintien est agencé au niveau d'un plan qui lui est propre, les plans étant sensiblement parallèles entre eux.

En particulier, chaque cadre de maintien est configuré de sorte à border la périphérie de chacune des deuxièmes faces des plaques d'un couple de plaques lorsqu'il est maintenu dans l'emplacement défini par ledit cadre de maintien.

De préférence, le premier organe comporte des rainures, le deuxième organe comporte des rainures, et chaque cadre de maintien comporte une des rainures du premier organe et une des rainures du deuxième organe, lesdites rainures de chaque cadre de maintien étant destinées à maintenir un couple de plaques correspondant dans l'emplacement défini par ledit cadre de maintien, dans la configuration d'assemblage les extrémités de chaque rainure du premier organe sont orientées chacune vers une extrémité correspondante d'une des rainures du deuxième organe.

En particulier, chaque rainure comporte un fond et deux paroi latérales s'étendant depuis le fond, la profondeur de ladite rainure étant comprise entre 2mm et 20mm, et la distance de séparation des parois latérales étant comprise entre 0.2mm et 2mm.

Selon une première réalisation, chacun des premier et deuxième organes comporte une première barre et une deuxième barre, un élément allongé, un premier ensemble de bras et un deuxième ensemble de bras, chaque bras du premier ensemble de bras reliant l'élément allongé à la première barre et chaque bras du deuxième ensemble de bras reliant l'élément allongé à la deuxième barre. Par ailleurs, pour chacun des premier et deuxième organes, chaque rainure comporte un premier tronçon formé dans la première barre, un deuxième tronçon formé dans un bras du premier ensemble de bras, un troisième tronçon formé dans l'élément allongé, un quatrième tronçon formé dans un bras du deuxième ensemble de bras, et un cinquième tronçon formé dans la deuxième barre.

En particulier, pour chacun des premier et deuxième organes, chaque bras du premier ensemble de bras est séparé d'un bras adjacent du premier ensemble de bras par une ouverture traversante du dispositif, et chaque bras du deuxième ensemble de bras est séparé d'un bras adjacent du deuxième ensemble de bras par une ouverture traversante du dispositif.

De préférence, les premier et deuxième organes du dispositif présentent un profil en forme générale de V d'où il résulte que chaque rainure s'étend selon sa longueur selon une forme générale d'un V.

Selon une deuxième réalisation, premier organe peut comporter des première et deuxième et troisième parois, les première et deuxième parois sont sensiblement parallèles entre elles et sensiblement perpendiculaires à la troisième paroi. Chaque rainure dudit premier organe comporte une partie formée dans la première paroi, une partie formée dans la deuxième paroi et une partie formée dans la troisième paroi. Par ailleurs, le deuxième organe comporte une paroi dans laquelle est formée chaque rainure dudit deuxième organe coopérant, dans la configuration d'assemblage, avec une rainure correspondante du premier organe pour définir un emplacement d'un des cadres de maintien correspondant destiné à recevoir un couple de plaques.

Dans la configuration d'assemblage, les premier et deuxième organes peuvent être assemblés par contact l'un contre l'autre, notamment de telle sorte que le deuxième organe repose par gravité sur le premier organe.

En particulier, les premier et deuxième organes sont en quartz.

Notamment, le dispositif peut être configuré pour varier entre la configuration d'assemblage et une configuration d'ouverture, dans la configuration d'ouverture le premier organe adopte une position par rapport au deuxième organe différente de celle adoptée dans la configuration d'assemblage de sorte à permettre l'insertion de plaques dans des parties de cadres de maintien formées dans le premier organe.

### Description sommaire des figures

L'invention sera mieux comprise à la lecture de la description qui va suivre, donnée uniquement à titre d'exemple non limitatif et faite en se référant aux dessins sur lesquels :
- La figure 1 illustre une vue en perspective du dispositif de maintien dans une configuration d'assemblage selon une première réalisation,
- La figure 2 illustre une vue en perspective du dispositif de maintien dans une configuration d'assemblage selon une deuxième réalisation,
- La figure 3 est en vue en coupe selon le plan de coupe C de la figure 1 représenté schématiquement en pointillés à la figure 1,
- La figure 4 illustre une configuration d'ouverture du dispositif de la figure 1,
- La figure 5 illustre une configuration d'ouverture du dispositif de la figure 2,
- La figure 6 illustre le dispositif de la figure 1 comportant des couples de plaques,
- La figure 7 illustre une vue en coupe du dispositif de la figure 6 selon la coupe D représentée schématiquement en pointillés à la figure 6,
- La figure 8 illustre schématiquement une coupe du dispositif de maintien placé dans une enceinte de diffusion d'un gaz.

Dans ces figures, les mêmes références sont utilisées pour désigner les mêmes éléments.

Par ailleurs, les éléments représentés sur les figures ne sont pas à l'échelle.

### Description de modes particuliers de réalisation

Le dispositif de maintien, aussi appelé simplement dispositif ou dispositif pour le maintien de plaques, décrit ci-après diffère de l'art antérieur notamment en ce qu'il permet de faciliter le traitement simultané (notamment par un procédé de diffusion, par exemple un procédé de dopage par diffusion d'éléments dopants tels que le phosphore ou le bore ; par un procédé de dépôt de couche diélectriques ou de couches conductrices par exemple en poly-silicium) d'une face seulement de plusieurs plaques, notamment de plaques de silicium.

Dans la présente description, une plaque comporte notamment deux faces opposées respectivement appelées première et deuxième faces de la plaque. Les première et deuxième faces d'une même plaque sont dites opposées car orientées vers des directions opposées. Par ailleurs, chaque plaque comporte un contour qui relie les première et deuxième faces de la plaque. Les première et deuxième faces sont des faces dites principales car elles présentent des surfaces plus importantes que celle du contour. Notamment, les première et deuxième faces d'une plaque sont séparées d'une distance qui donne l'épaisseur de la plaque.

Dans la présente description, par sensiblement parallèle, on entend exactement parallèle ou parallèle à plus ou moins 10%. Par ailleurs, par « sensiblement perpendiculaire », on entend exactement perpendiculaire ou perpendiculaire à plus ou moins 10%.

Pour faciliter le traitement d'une seule des faces (ou du côté d'une seule des faces), de chaque plaque maintenue dans le dispositif, il est proposé d'utiliser un dispositif de maintien qui permet de maintenir les plaques par couples. Pour chaque couple de plaques, les plaques sont placées dans le dispositif et maintenues par ce dernier de telle sorte que les premières faces des plaques soient orientées l'une en direction de l'autre et que les deuxièmes faces des plaques soient orientées vers une zone de passage d'un ou plusieurs gaz.

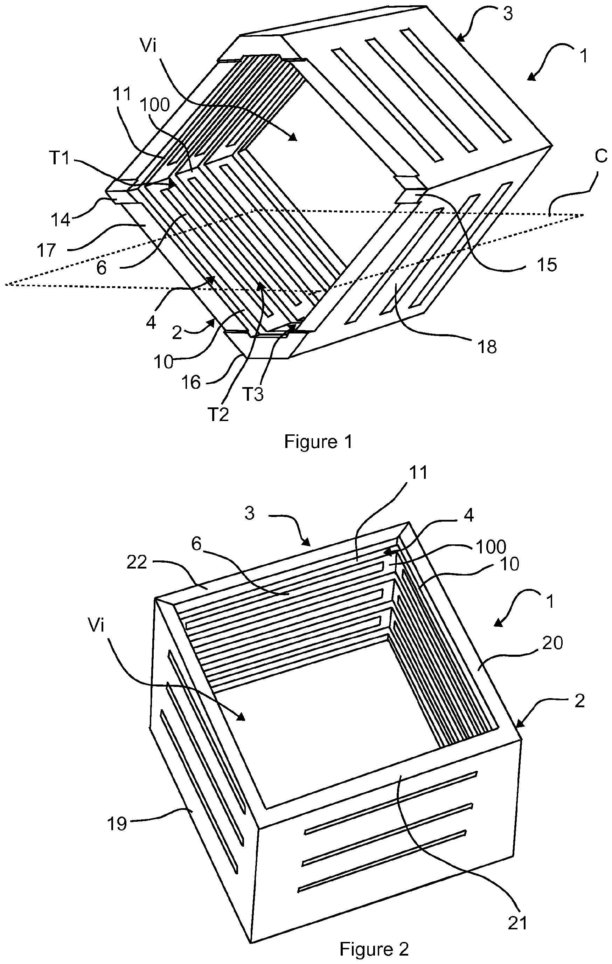

Comme illustré en figures 1 à 3, le dispositif 1 pour le maintien de plaques comportant chacune un matériau semi-conducteur et présentant chacune des première et deuxième faces (c'est à dire que chaque plaque est munie de première et deuxième faces) est un dispositif qui comporte un premier organe 2 et un deuxième organe 3. Dans le domaine, un dispositif pour le maintien de plaques est aussi appelé nacelle. Dans la suite de la description, lorsqu'il est fait référence à une plaque, il s'agit d'une plaque comportant un matériau semi-conducteur. Par exemple, la plaque peut comporter un substrat semi-conducteur et éventuellement des couches formées sur le substrat semi-conducteur. On dit alors que le substrat semi-conducteur est constitué par le matériau semi-conducteur de la plaque. Dans la présente description, les plaques peuvent être des plaques de silicium, notamment destinées à former des cellules photovoltaïques.

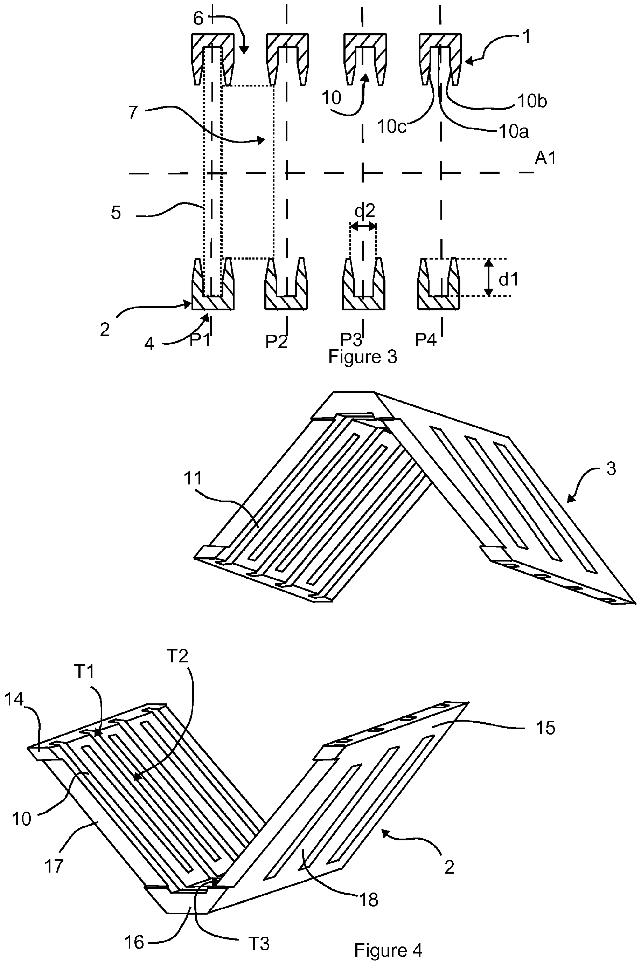

En particulier, le premier organe 2 est assemblé au deuxième organe 3 de sorte à délimiter une pluralité de cadres de maintien 4 définissant chacun un emplacement 5 (schématisé en pointillés à la figure 3) destiné à la réception d'un couple de plaques à maintenir dont les premières faces sont orientées l'une vers l'autre. On dit alors que le dispositif comporte le premier organe 2 assemblé au deuxième organe 3, et le dispositif peut être dans une configuration d'assemblage. On comprend alors que les dimensions de chaque emplacement 5 sont adaptées à la réception de deux plaques. Chaque cadre de maintien 4 est adjacent à au moins un autre cadre de maintien 4. Par ailleurs, pour chaque couple de cadres de maintien 4 adjacents, le dispositif comporte au moins un passage 6 reliant, entre lesdits cadres de maintien 4 adjacents, l'extérieur du dispositif à un espace 7 (schématisé en pointillés à la figure 3) séparant les emplacements 5 définis par lesdits cadres de maintien 4 adjacents. Pour chaque couple de cadres de maintien 4 adjacents, le nombre de passages 6 associé peut être supérieur à deux, dans l'exemple illustré en figures 1 et 2 il existe quatre passages 6 par couple de cadres de maintien 4 adjacents. La présence d'un ou plusieurs passages 6 est destinée à améliorer la circulation d'un ou plusieurs gaz utilisés pour le traitement des plaques et notamment lorsque l'on souhaite réaliser un dépôt ou une étape de diffusion sur une des faces seulement des plaques. Chaque passage 6 peut être une ouverture formée dans le dispositif.

Selon une autre formulation, on dit que pour chaque couple de cadres de maintien 4 adjacents, le dispositif comporte au moins un passage 6 agencé de sorte à permettre la circulation d'un ou plusieurs gaz issus de l'extérieur du dispositif entre deux emplacements adjacents définis par les cadres de maintien 4 adjacents dudit couple de cadres, notamment lorsque lesdits deux emplacements sont occupés chacun par un couple correspondant de plaques. Les passages peuvent adopter la forme de fentes ou de trous percés permettant la circulation des gaz. Les caractéristiques visées dans le présent paragraphe et le paragraphe précédent correspondent à une configuration d'assemblage du dispositif dans laquelle est le dispositif de maintien. Notamment, chaque espace 7 séparant les emplacements 5 définis par lesdits cadres de maintien 4 adjacents est tel que les emplacements sont séparés d'une distance comprise entre 1mm et 10mm, et plus particulièrement d'une distance comprise entre 2mm et 5mm.

Par définition, un cadre permet d'encadrer de manière continue un emplacement correspondant en vue de participer au maintien d'un couple de plaques. Chaque cadre de maintien 4 permet d'une part de maintenir et de bloquer un couple de plaques au sein de l'emplacement correspondant au contraire de l'art antérieur qui propose une simple utilisation d'encoches.

Notamment, dans la configuration d'assemblage, les cadres de maintien 4 sont solidaires entre eux et pour chaque espace 7 séparant deux emplacements 5 adjacents, le dispositif de maintien 1 comporte autant de passages 6 que le cadre de maintien 4 comporte de côtés. En particulier, chaque cadre de maintien 4 comporte quatre côtés. L'augmentation du nombre de passages 6 permet de favoriser le passage du ou des gaz destinés par exemple à former une couche d'un matériau sur les deuxièmes faces des plaques lorsqu'elles sont maintenues par couple dans le dispositif de maintien.

Selon une mise en œuvre, dans la configuration d'assemblage, chaque cadre de maintien 4 comporte quatre coins et chaque coin d'un cadre de maintien 4 est relié à un coin d'au moins un cadre adjacent par un élément de liaison 100 (figures 1 et 2) de telle sorte que pour chaque couple de cadres de maintien 4 adjacents le dispositif comporte quatre passages délimités par les cadres de maintien 4 adjacents et les éléments de liaison 100 correspondants.

En particulier, dans la configuration d'assemblage, les premier et deuxième organes 2, 3 sont assemblés par contact l'un contre l'autre, notamment de telle sorte que le deuxième organe 3 repose par gravité sur le premier organe 2.

Le premier organe 2 est, de préférence, une pièce monolithique et le deuxième organe 3 est de préférence une pièce monolithique.

En fait, l'assemblage des premier et deuxième organes 2, 3 est tel qu'il définit un volume interne Vi du dispositif de maintien 1 au sein duquel les emplacements 5 et les espaces 7 de séparation entre emplacements 5 sont présents. Chaque passage 6 évoqué ci-avant permet de mettre en communication un espace correspondant avec l'extérieur du dispositif de maintien lorsque les emplacements 5 séparés par ledit espace 7 sont occupés par des couples de plaques.

Dans la configuration d'assemblage, le dispositif de maintien 1 peut comporter quatre parois latérales reliées entre elles pour former les cadres, des ouvertures étant agencées dans ces parois latérales pour former les passages 6 évoqués ci-avant.

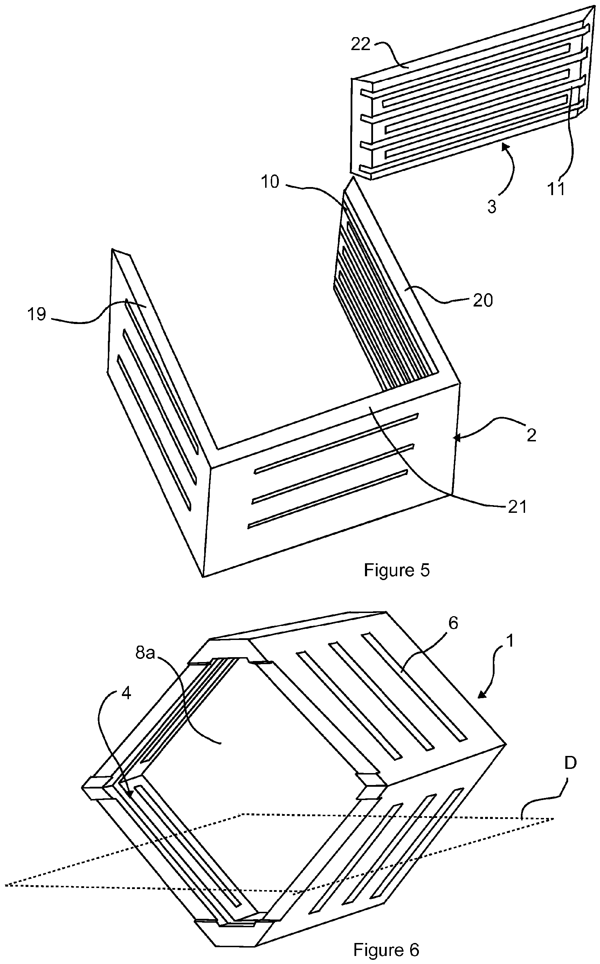

Dans la configuration d'assemblage du dispositif où les premier et deuxième organes 2, 3 sont assemblés, on comprend que l'insertion ou le retrait de plaques n'est pas permis car les cadres de maintien 4 formés empêchent cela en encadrant les emplacements 5. En ce sens, le dispositif de maintien 1 peut aussi adopter une configuration d'ouverture dans laquelle les premier et deuxième organes 2, 3 sont désassemblés de sorte à permettre l'insertion ou le retrait de plaques. Plus généralement, on dit que le dispositif 1 est configuré pour varier entre la configuration d'assemblage (figures 1 et 2) et la configuration d'ouverture (figures 4 et 5), dans la configuration d'ouverture le premier organe 2 adopte une position par rapport au deuxième organe 3 différente de la position entre le premier organe 2 et le deuxième organe 3 adoptée dans la configuration d'assemblage de sorte à permettre l'insertion, ou le cas échéant le retrait, de plaques dans des parties de cadres de maintien formées dans le premier organe 2.

De préférence, le dispositif 1 est configuré de telle sorte que le deuxième organe 3 peut présenter une mobilité par rapport au premier organe 2. Selon une autre formulation, on dit que le deuxième organe 3 est amovible, notamment du premier organe 2. Ceci permet notamment le passage de la configuration d'assemblage à la configuration d'ouverture, ou inversement.

Les figures 1 et 2 illustrent justement la configuration d'assemblage qui comporte quatre cadres de maintien 4, et les figures 4 et 5 illustrent la configuration d'ouverture respectivement pour la réalisation de la figure 1 et de la figure 2.

Dans la présente description, chaque cadre de maintien 4 est formé lorsque le premier organe 2 et le deuxième organe 3 sont assemblés. Lorsque le premier organe 2 et le deuxième organe 3 ne sont pas assemblés, ils comportent chacun des parties destinées à former des cadres.

Comme illustré en figures 1 et 2 chaque cadre de maintien 4 peut comporter une entaille continue délimitant un encadrement d'un emplacement correspondant.

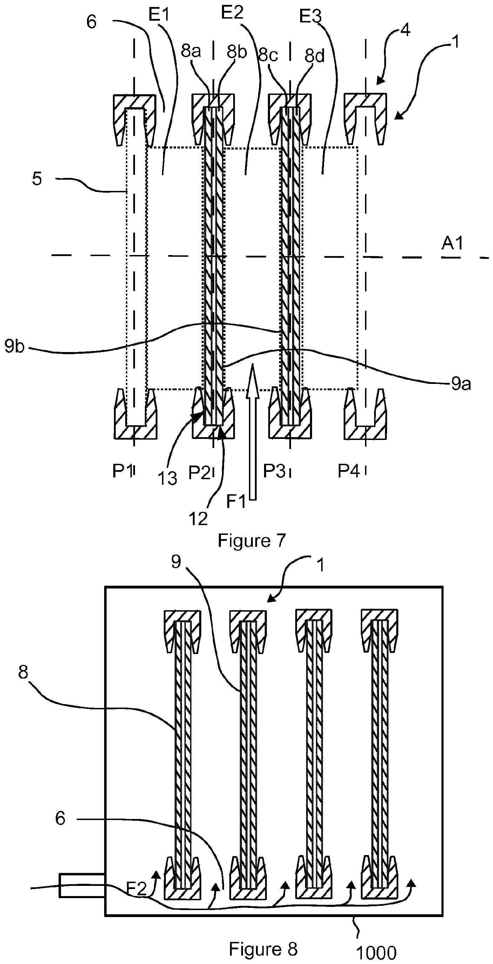

En fait, chaque cadre 4 de maintien peut former localement une cage permettant de maintenir un couple de plaques correspondant dans l'emplacement associé au sein du dispositif de maintien 1. On dit aussi que l'assemblage du premier organe 2 avec le deuxième organe 3 dans la configuration d'assemblage du dispositif permet de former une armature d'encadrement de couples de plaques. Chaque cadre de maintien 4 est notamment tel que, dans la configuration d'assemblage et lorsqu'un couple de plaques est présent dans l'emplacement défini par ledit cadre de maintien 4, il entoure/ceinture les contours des deux plaques dudit couple de plaques et borde la périphérie de chacune des deuxièmes faces des deux plaques du couple de plaques. Selon une autre formulation, on dit que chaque cadre de maintien 4 est configuré, c'est à dire conformé ou agencé, de sorte à border la périphérie de chacune des deuxièmes faces des plaques d'un couple de plaques lorsque ledit couple de plaques est maintenu dans l'emplacement défini par ledit cadre de maintien 4. Cet agencement particulier permet de former une barrière à gaz efficace évitant la diffusion de gaz entre les premières faces des plaques d'un même couple de plaques placé dans un emplacement correspondant. Le matériau utilisé pour former le premier organe 2 et le deuxième organe 3 peut préférentiellement supporter des températures comprises entre 600°C et 1100°C et peut être du quartz ou du carbure de silicium. Les figures 6 et 7 illustrent justement le dispositif de maintien 1 qui comporte pour l'exemple deux couples de plaques 8a, 8b, 8c, 8d. La vue en coupe de la figure 7 permet de visualiser les espaces E1, E2, E3 entre les emplacements 5 définis par les cadres de maintien 4. Les passages 6 permettent à un gaz d'atteindre (selon une diffusion du gaz selon la flèche F1 par exemple) les deuxièmes faces 9a, 9b de deux plaques 8b, 8c se faisant face au sein du dispositif.

En particulier, chaque cadre de maintien 4 est agencé au niveau d'un plan P1, P2, P3, P4 (chacun perpendiculaire au plan des figures 3 et 7) qui lui est propre, les plans P1, P2, P3, P4 étant sensiblement parallèles entre eux, et notamment échelonnés (de préférence à intervalles réguliers) selon un axe A1 par rapport auquel lesdits plans sont sensiblement perpendiculaires.

Selon une mise en œuvre, le premier organe 2 comporte des rainures 10 (figures 1, 2, 4 et 5) et le deuxième organe 3 comporte des rainures 11. Dans ce cas, chaque cadre de maintien 4 comporte une des rainures 10 du premier organe 2 et une des rainures 11 du deuxième organe 3. Lesdites rainures de chaque cadre de maintien 4 sont destinées à maintenir un couple de plaques correspondant dans l'emplacement défini par ledit cadre de maintien 4. Selon une autre formulation, pour chaque cadre de maintien 4, les rainures dudit cadre de maintien sont destinées à encadrer un couple de plaques et à le maintenir au sein de l'emplacement correspondant. Dans la configuration d'assemblage, les extrémités de chaque rainure 10 du premier organe 2 sont orientées chacune vers une extrémité correspondante d'une des rainures 11 du deuxième organe 3. Autrement dit, chaque cadre de maintien 4 peut comporter deux rainures placées en continuité. En particulier, les rainures 10 et 11 sont des rainures ouvertes à leurs extrémités longitudinales de telle sorte que, dans la configuration d'assemblage, pour chaque cadre de maintien 4, les rainures dudit cadre de maintien 4 coopèrent pour être en continuité l'une de l'autre. Notamment, les rainures participent à délimiter le volume interne Vi du dispositif de maintien. Pour chaque cadre de maintien 4, la coopération de deux rainures permet de délimiter l'entaille décrite ci-avant. En particulier chaque rainure appartient à une partie de cadre de maintien correspondante telle que décrite ci-avant.

Plus particulièrement, comme illustré en figure 3 chaque rainure 10 (ceci étant aussi valable pour les rainures 11) comporte un fond 10a et deux paroi latérales 10b, 10c s'étendant depuis le fond 10a. Les parois latérales 10b, 10c des rainures s'étendent notamment depuis le fond 10a correspondant en direction d'une zone centrale du dispositif. Plus généralement, les rainures de chaque cadre de maintien 4 sont configurées pour délimiter un encadrement de maintien d'un couple de plaques, en ce sens, le fond desdits rainures est orienté vers l'intérieur du dispositif de maintien.

L'utilisation de rainures au sein de chaque cadre de maintien présente deux avantages, le premier est d'assurer un maintien et un blocage d'un couple de plaques dans un emplacement 5. Le deuxième avantage est que les rainures d'un cadre de maintien 4 permettent via leurs parois latérales de border la périphérie des deuxièmes faces des plaques d'un couple de plaques maintenu dans l'emplacement 5 correspondant : il en résulte, pour chaque cadre de maintien 4 la création de surfaces du dispositif de maintien 1 orientées vers les plaques qui participent au piégeage de ou des gaz évoqués ci-avant évitant ainsi à ces gaz de passer entre les plaques d'un même couple de plaques. La mobilité des gaz réactifs (par exemple de l'oxygène O₂, du POCl₃ et du P₂O₅ qui peuvent être cumulés, par exemple pour une diffusion utilisant POCl₃ on injecte généralement du O₂ et du POCl₃ qui forment le composé P₂O₅ : ces trois gaz réactifs se retrouvent dans l'enceinte d'un four dans lequel peut être placé le dispositif 1 et interagissent avec les surfaces présentes dans le four) est définie par un coefficient de diffusion et une longueur de diffusion en phase vapeur. Pour une molécule de gaz donnée, le coefficient de diffusion se retrouve en compétition avec le coefficient d'adsorption du gaz sur une surface qui permet à la molécule d'interagir avec la surface. Plus particulièrement, le coefficient d'adsorption dépend de la capacité du gaz à se déposer, de la température de la plaque sur laquelle il doit se déposer et de la pression partielle du gaz. Selon une autre formulation, le coefficient d'adsorption correspond au taux de réactivité des gaz, c'est-à-dire à leur capacité de se déposer plus ou moins rapidement sur une surface portée à une température donnée. Le fait de border, par les parois latérales 10b et 10c des rainures 10, 11, les deuxièmes faces des plaques de chaque couple de plaques permet d'éviter le passage des gaz entre les parois des rainures et la plaque associée de sorte que seule la deuxième face soit soumise au(x) gaz. On comprend alors que la profondeur des rainures et donc la hauteur de leurs parois latérales joue un rôle dans l'efficacité du piégeage. En effet, une surface supplémentaire apportée sur l'ensemble de la périphérie 13 (figure 7) des plaques contribuera à accentuer l'adsorption des molécules de gaz préférentiellement sur les parois des rainures 10, 11, empêchant ainsi lesdites molécules d'atteindre le fond des rainures.

Selon une réalisation, la profondeur d1 (figure 3) de chaque rainure 10 (ceci étant aussi valable pour la rainure 11) est comprise entre 2mm et 2cm, de préférence entre 5mm et 10mm. La profondeur d1 peut être égale à 7mm. On comprend de ce qui a été dit ci-dessus que la profondeur exacte des rainures peut être fonction de la réactivité des gaz utilisés : plus les gaz seront réactifs, moins les rainures auront besoin d'être profondes. Ces dimensions, permettent de border les plaques d'un couple de plaques de manière satisfaisante tout en évitant la diffusion de gaz entre les plaques du couple. Par ailleurs, la distance de séparation d2 des parois latérales 10b, 10c de ladite rainure 10 (ceci étant aussi valable pour la rainure 11) est comprise entre 0,2mm et 2mm et correspond à l'épaisseur d'un couple de plaques (qui peut varier selon les procédés et les technologies utilisées) auquel on ajoute entre 100µm et 300µm, cette distance de séparation est préférentiellement supérieure à l'épaisseur cumulée des deux plaques à maintenir par les rainures concernées de sorte à permettre un jeu fonctionnel pour éviter la casse des plaques lors de leur dilatation si elles sont soumises à une élévation de température. En résumé, on a d2=2xE₁+200µm plus ou moins 100µm, avec E₁ l'épaisseur d'une plaque.

En résumé, les fonds de deux rainures d'un cadre de maintien participant à définir un même emplacement sont configurés pour, lorsqu'un couple de plaques est maintenu par ledit cadre de maintien 4, entourer un contour 12 (figure 7) des plaques 8a, 8b d'un couple de plaques 8a, 8b et les parois latérales desdites deux rainures sont destinées à border la périphérie 13 de chaque deuxième face desdites plaques du couple de plaques.

Toujours pour éviter la détérioration des plaques lorsqu'elles subissent un traitement thermique lors de leur présence dans les emplacements, chaque rainure est notamment telle que les parois latérales présentent au moins des portions en regard et divergentes dans une direction opposée au fond de la rainure.

Selon une première réalisation, illustrée en figures 1 et 4, chacun des premier et deuxième organes 2, 3 comporte une première barre 14 et une deuxième barre 15. Notamment, la première barre 14 du premier organe 2 est en contact avec la première barre 14 du deuxième organe 3 dans la configuration d'assemblage, et la deuxième barre 15 du premier organe 2 est en contact avec la deuxième barre 15 du deuxième organe 3 dans la configuration d'assemblage (figure 1). Chacun des premier et deuxième organes 2, 3 comporte en outre un élément allongé 16, un premier ensemble de bras 17 et un deuxième ensemble de bras 18. Chaque bras 17 du premier ensemble de bras relie l'élément allongé 16 à la première barre 14 et chaque bras 18 du deuxième ensemble de bras relie l'élément allongé 16 à la deuxième barre 15. Selon cette première réalisation, chaque rainure 10 du premier organe comporte un premier tronçon T1 formé dans la première barre 14 du premier organe, un deuxième tronçon T2 formé dans un bras 17 du premier ensemble de bras du premier organe, un troisième tronçon T3 formé dans l'élément allongé 16 du premier organe, un quatrième tronçon formé dans un bras 18 du deuxième ensemble de bras du premier organe, et un cinquième tronçon formé dans la deuxième barre 15 du premier organe. Par ailleurs, chaque rainure 11 du deuxième organe comporte un premier tronçon formé dans la première barre du deuxième organe, un deuxième tronçon formé dans un bras du premier ensemble de bras du deuxième organe, un troisième tronçon formé dans l'élément allongé du deuxième organe, un quatrième tronçon formé dans un bras du deuxième ensemble de bras du deuxième organe, et un cinquième tronçon formé dans la deuxième barre du deuxième organe. Notamment, pour un même organe, l'élément allongé 16 et les première et deuxième barres 14, 15 sont sensiblement parallèles entre eux. En particulier, chaque bras est associé à une seule rainure. Notamment, pour tout couple de bras adjacents d'un même ensemble de bras du premier organe 2 et du deuxième organe 3, lesdits bras sont séparés par un passage du dispositif tel que décrit précédemment. Ici, lorsque qu'un tronçon est dit « formé dans un élément » on entend que l'élément comporte une surface délimitant le tronçon.

Selon la première réalisation, chaque rainure des premier et deuxième organes 2, 3 appartient à un demi-cadre d'un cadre formé dans la configuration d'assemblage.

Selon la première réalisation, le premier organe 2 et le deuxième organe 3 présentent préférentiellement chacun une partie concave et l'association des parties concaves du premier organe 2 et du deuxième organe 3 dans la configuration d'assemblage forme le volume interne Vi du dispositif de maintien 1. Sur les figures 1 et 4, on voit clairement que la partie concave du premier organe 2 comporte les rainures du premier organe 2 et que la partie concave du deuxième organe 3 comporte les rainures du deuxième organe 3.

Préférentiellement, selon la première réalisation, pour le premier organe 2, les bras 17 du premier ensemble de bras sont sensiblement parallèles entre eux et s'étendent notamment selon un même plan, et les bras 18 du deuxième ensemble de bras sont sensiblement parallèles entre eux et s'étendent notamment selon un même plan. Par ailleurs, selon un exemple particulier, chaque bras 17 du premier ensemble de bras du premier organe 2 forme un angle de 90 degrés avec un bras 18 associé du deuxième ensemble de bras. Pour le deuxième organe 3, les bras du premier ensemble de bras sont sensiblement parallèles entre eux et s'étendent notamment selon un même plan, et les bras du deuxième ensemble de bras sont sensiblement parallèles entre eux et s'étendent notamment selon un même plan. Par ailleurs, selon un exemple particulier, chaque bras du premier ensemble de bras du deuxième organe 3 forme un angle de 90 degrés avec un bras associé du deuxième ensemble de bras du deuxième organe 3. Lorsque l'on parle de bras associés, on entend que ces bras sont parcourus par une même rainure.

Selon la première réalisation, ceci étant valable pour le premier organe et le deuxième organe, chaque bras du premier ensemble de bras est notamment séparé d'un bras adjacent du premier ensemble de bras par une ouverture traversante du dispositif, et chaque bras du deuxième ensemble de bras est notamment séparé d'un bras adjacent du deuxième ensemble de bras par une ouverture traversante du dispositif. Les ouvertures traversantes formant chacune un passage 6 tel que décrit précédemment.

Plus généralement, les premier et deuxième organes 2, 3 du dispositif présentent un profil en forme générale de V d'où il résulte que chaque rainure 10, 11 s'étend selon sa longueur selon une forme générale d'un V. Les deux branches du V forment ici préférentiellement un angle de 90 degrés entre elles.

La première réalisation décrite ci-avant est tout particulièrement adaptée dans le cadre du chargement des plaques à la verticale. Dans ce cas, le premier organe 2 peut reposer sur un support via son élément allongé 16 et les plaques sont installées verticalement par couple dans les rainures du premier organe 2. Ensuite, le deuxième organe 3 est reporté sur le premier organe 2 pour former les cadres de maintien 4 évoqués ci-dessus par insertion de parties de contours libres des plaques dans les rainures 11 du deuxième organe 3.

Selon une deuxième réalisation illustrée en figures 2 et 5, le premier organe 2 comporte des première, deuxième et troisième parois 19, 20, 21, les première et deuxième parois 19, 20 sont sensiblement parallèles entre elles et sensiblement perpendiculaires à la troisième paroi 21. Chaque rainure 10 du premier organe 2 comporte une partie formée dans la première paroi 19, une partie formée dans la deuxième paroi 20 et une partie formée dans la troisième paroi 21. Par ailleurs, le deuxième organe 3 comporte une paroi 22 dans laquelle est formée chaque rainure 11 dudit deuxième organe 3. Chaque rainure 11 du deuxième organe 3 coopérant, dans la configuration d'assemblage, avec une rainure 10 correspondante du premier organe 2 pour définir un emplacement d'un des cadres de maintien 4 correspondant destiné à recevoir un couple de plaques. Dans la configuration d'assemblage, le deuxième organe 3 vient, de préférence, en contact avec des extrémités des première et deuxième parois 19, 20 opposées à la troisième paroi 21. Ici, lorsqu'une « partie de rainure est formée dans un élément », on entend que l'élément comporte une surface délimitant ladite partie. Dans le présent paragraphe, le mot perpendiculaire peut être remplacé par orthogonal, sensiblement orthogonal correspondant à orthogonal ou orthogonal à plus ou moins 10%.

Cette deuxième réalisation est tout particulièrement adaptée pour le cas d'un chargement des plaques à l'horizontal. En effet, le premier organe 2 peut être placé sur un support définissant un plan horizontal de sorte que les première, deuxième et troisième parois s'étendent de ce support et que les rainures du premier organe 2 s'étendent dans des plans parallèles entre eux et orthogonaux, ou perpendiculaire, à une direction verticale orthogonale, ou perpendiculaire, au plan horizontal sur lequel peut reposer le premier organe 2.

Selon cette deuxième réalisation, le premier organe 2 comporte une partie concave dans laquelle les rainures du premier organe 2 sont formées et le deuxième organe 3 adopte la forme d'une plaque venant se positionner contre le premier organe 2 pour délimiter, avec la partie concave du premier organe 2, le volume interne Vi du dispositif de maintien au sein duquel sont agencées les rainures du premier organe 2 et du deuxième organe 3.

De manière générale, les premier et deuxième organes 2, 3 sont en quartz ou en carbure de silicium, et sont préférentiellement chacun monolithique. Le quartz (SiO₂) est le matériau le plus répandu pour le support de plaques semiconducteurs car il présente deux avantages majeurs dont le premier étant son faible coût de fabrication et sa réponse rapide aux variations de températures lié à sa transparence dans le domaine des rayonnements infra rouge. Le carbure de silicum (SiC) est quant à lui plus cher, en particulier pour les designs de supports complexes, et sa réponse en température moins rapide que pour le quartz. Toutefois, le SiC a l'avantage principal d'avoir une très bonne résistance aux contraintes thermomécaniques générées par les variations de températures dans l'enceinte d'un four de diffusion.

Concernant la deuxième réalisation, le dispositif peut être placé de telle manière que la paroi 22 repose par gravité sur le premier organe, alternativement il est possible d'ajouter au dispositif un système de fermeture permettant de maintenir l'assemblage.

Comme illustré en figure 8, le dispositif 1 peut être placé dans une enceinte 1000 dans laquelle est diffusé un gaz (flèche F2) qui peut atteindre les deuxièmes faces 9 des plaques 8 en passant par les passages 6. Le gaz peut par exemple permettre de doper les deuxièmes faces 9 en vue de former des cellules photovoltaïques. Le dispositif 1 peut être utilisé dans tout procédé nécessitant de travailler, notamment en utilisant un gaz, sur une seule face de plaque et ce pour plusieurs plaques à la fois.

## Revendications

1. Dispositif (1) pour le maintien de plaques comportant chacune un matériau semi-conducteur et présentant chacune des première et deuxième faces, ledit dispositif comportant un premier organe (2) et un deuxième organe (3), et ledit dispositif comportant, dans une configuration d'assemblage du dispositif :
- le premier organe (2) assemblé au deuxième organe (3) de sorte à délimiter une pluralité de cadres de maintien (4) définissant chacun un emplacement (5) destiné à la réception d'un couple de plaques à maintenir, dont les premières faces sont orientées l'une vers l'autre, chaque cadre de maintien (4) étant adjacent à au moins un autre cadre de maintien (4),
- pour chaque couple de cadres de maintien (4) adjacents, un passage (6) reliant, entre lesdits cadres de maintien (4) adjacents, l'extérieur du dispositif à un espace (7) séparant les emplacements (5) définis par lesdits cadres de maintien (4) adjacents,
**caractérisé en ce que** chaque cadre de maintien (4) est configuré de sorte à border la périphérie de chacune des deuxièmes faces des plaques d'un couple de plaques lorsqu'il est maintenu dans l'emplacement défini par ledit cadre de maintien (4).

2. Dispositif selon la revendication précédente, **caractérisé en ce que** chaque cadre de maintien (4) est agencé au niveau d'un plan qui lui est propre, les plans étant sensiblement parallèles entre eux.

3. Dispositif selon l'une quelconque des revendications précédentes, **caractérisé en ce que** le premier organe (2) comporte des rainures (10), le deuxième organe (3) comporte des rainures (11), et **en ce que** chaque cadre de maintien (4) comporte une des rainures (10) du premier organe (2) et une des rainures (11) du deuxième organe (3), lesdites rainures de chaque cadre de maintien (4) étant destinées à maintenir un couple de plaques correspondant dans l'emplacement (5) défini par ledit cadre de maintien (4), dans la configuration d'assemblage les extrémités de chaque rainure (10) du premier organe (2) sont orientées chacune vers une extrémité correspondante d'une des rainures (11) du deuxième organe (3).

4. Dispositif selon la revendication 3, **caractérisé en ce que** chaque rainure (10, 11) comporte un fond (10a) et deux paroi latérales (10b, 10c) s'étendant depuis le fond (10a), la profondeur de ladite rainure étant comprise entre 2mm et 20mm, et la distance de séparation des parois latérales étant comprise entre 0.2mm et 2mm.

5. Dispositif selon l'une quelconque des revendications 3 à 4, **caractérisé en ce que** chacun des premier et deuxième organes (2, 3) comporte :
- une première barre (14) et une deuxième barre (15),
- un élément allongé (16),
- un premier ensemble de bras (17) et un deuxième ensemble de bras (18), chaque bras (17) du premier ensemble de bras reliant l'élément allongé (16) à la première barre (14) et chaque bras (18) du deuxième ensemble de bras reliant l'élément allongé (16) à la deuxième barre (15),
et **en ce que** pour chacun des premier et deuxième organes, chaque rainure (10, 11) comporte un premier tronçon (T1) formé dans la première barre (14), un deuxième tronçon (T2) formé dans un bras (17) du premier ensemble de bras, un troisième tronçon (T3) formé dans l'élément allongé (16), un quatrième tronçon formé dans un bras (18) du deuxième ensemble de bras, et un cinquième tronçon formé dans la deuxième barre (15).

6. Dispositif selon la revendication précédente, **caractérisé en ce que**, pour chacun des premier et deuxième organes (2, 3), chaque bras du premier ensemble de bras est séparé d'un bras adjacent du premier ensemble de bras par une ouverture traversante du dispositif, et chaque bras du deuxième ensemble de bras est séparé d'un bras adjacent du deuxième ensemble de bras par une ouverture traversante du dispositif.

7. Dispositif selon l'une quelconque des revendications 3 à 6, **caractérisé en ce que** les premier et deuxième organes (2, 3) du dispositif présentent un profil en forme générale de V d'où il résulte que chaque rainure s'étend selon sa longueur selon une forme générale d'un V.

8. Dispositif selon la revendication 3 ou la revendication 4, **caractérisé en ce que** le premier organe (2) comporte des première et deuxième et troisième parois (19, 20, 21), les première et deuxième parois (19, 20) sont sensiblement parallèles entre elles et sensiblement perpendiculaires à la troisième paroi (21), chaque rainure (10) dudit premier organe (2) comporte une partie formée dans la première paroi (19), une partie formée dans la deuxième paroi (20) et une partie formée dans la troisième paroi (21), et **en ce que** le deuxième organe (3) comporte une paroi (22) dans laquelle est formée chaque rainure (11) dudit deuxième organe (3) coopérant, dans la configuration d'assemblage, avec une rainure (10) correspondante du premier organe (2) pour définir un emplacement d'un des cadres de maintien (4) correspondant destiné à recevoir un couple de plaques.

9. Dispositif selon l'une quelconque des revendications précédentes, **caractérisé en ce que**, dans la configuration d'assemblage, les premier et deuxième organes (2, 3) sont assemblés par contact l'un contre l'autre, notamment de telle sorte que le deuxième organe (3) repose par gravité sur le premier organe (2).

10. Dispositif selon l'une quelconque des revendications précédentes, **caractérisé en ce que** les premier et deuxième organes (2, 3) sont en quartz.

11. Dispositif selon l'une quelconque des revendications précédentes, **caractérisé en ce qu'**il est configuré pour varier entre la configuration d'assemblage et une configuration d'ouverture, dans la configuration d'ouverture le premier organe (2) adopte une position par rapport au deuxième organe (3) différente de celle adoptée dans la configuration d'assemblage de sorte à permettre l'insertion de plaques dans des parties de cadres de maintien formées dans le premier organe (2).

## Patentansprüche

1. Vorrichtung (1) zum Halten von Scheiben, die jeweils ein Halbleitermaterial umfassen und jeweils eine erste und eine zweite Fläche aufweisen, wobei die Vorrichtung ein erstes Glied (2) und ein zweites Glied (3) umfasst, und wobei die Vorrichtung in einer zusammengebauten Konfiguration der Vorrichtung umfasst:
- das erste Glied (2) mit dem zweiten Glied (3) zusammengebaut, sodass eine Vielzahl von Halterahmen (4) begrenzt werden, die jeweils eine Stelle (5) definieren, die zur Aufnahme eines zu haltenden Scheibenpaares, dessen erste Flächen einander zugewandt sind, bestimmt ist, wobei jeder Halterahmen (4) an mindestens einen weiteren Halterahmen (4) angrenzt,
- bei jedem Paar aneinandergrenzender Halterahmen (4) einen Durchgang (6), der zwischen den aneinandergrenzenden Halterahmen (4) die Außenseite der Vorrichtung mit einem Raum (7) verbindet, der die von den aneinandergrenzenden Halterahmen (4) definierten Stellen (5) trennt,
**dadurch gekennzeichnet, dass** jeder Halterahmen (4) so ausgelegt ist, dass er den Umfang jeder der zweiten Flächen der Scheiben eines Scheibenpaares, wenn es an der vom Halterahmen (4) definierten Stelle gehalten wird, umsäumt.

2. Vorrichtung nach dem vorstehenden Anspruch, **dadurch gekennzeichnet, dass** jeder Halterahmen (4) auf Höhe einer ihm eigenen Ebene eingerichtet ist, wobei die Ebenen im Wesentlichen parallel zueinander sind.

3. Vorrichtung nach einem der vorstehenden Ansprüche, **dadurch gekennzeichnet, dass** das erste Glied (2) Nuten (10) umfasst, das zweite Glied (3) Nuten (11) umfasst, und dadurch, dass jeder Halterahmen (4) eine der Nuten (10) des ersten Gliedes (2) und eine der Nuten (11) des zweiten Gliedes (3) umfasst, wobei die Nuten jedes Halterahmens (4) dazu bestimmt sind, ein entsprechendes Scheibenpaar an der vom Halterahmen (4) definierten Stelle (5) zu halten, wobei in der zusammengebauten Konfiguration die Enden jeder Nut (10) des ersten Gliedes (2) jeweils zu einem entsprechenden Ende einer der Nuten (11) des zweiten Gliedes (3) ausgerichtet sind.

4. Vorrichtung nach Anspruch 3, **dadurch gekennzeichnet, dass** jede Nut (10, 11) einen Boden (10a) und zwei Seitenwände (10b, 10c) umfasst, die sich vom Boden (10a) erstrecken, wobei die Tiefe der Nut im Bereich zwischen 2 mm und 20 mm liegt, und der Trennabstand der Seitenwände im Bereich zwischen 0,2 mm und 2 mm liegt.

5. Vorrichtung nach einem der Ansprüche 3 bis 4, **dadurch gekennzeichnet, dass** jedes aus dem ersten und dem zweiten Glied (2, 3) umfasst:
- eine erste Leiste (14) und eine zweite Leiste (15),
- ein längliches Element (16),
- einen ersten Satz Arme (17) und einen zweiten Satz Arme (18), wobei jeder Arm (17) des ersten Armsatzes das längliche Element (16) mit der ersten Leiste (14) verbindet, und jeder Arm (18) des zweiten Armsatzes das längliche Element (16) mit der zweiten Leiste (15) verbindet,
und dadurch, dass bei jedem aus dem ersten und dem zweiten Glied jede Nut (10, 11) ein in der ersten Leiste (14) gebildetes erstes Teilstück (T1), ein in einem Arm (17) des ersten Armsatzes gebildetes zweites Teilstück (T2), ein im länglichen Element (16) gebildetes drittes Teilstück (T3), ein in einem Arm (18) des zweiten Armsatzes gebildetes viertes Teilstück, und ein in der zweiten Leiste (15) gebildetes fünftes Teilstück umfasst.

6. Vorrichtung nach dem vorstehenden Anspruch, **dadurch gekennzeichnet, dass** bei jedem aus dem ersten und dem zweiten Glied (2, 3) jeder Arm des ersten Armsatzes durch eine Durchgangsöffnung der Vorrichtung von einem angrenzenden Arm des ersten Armsatzes getrennt ist, und jeder Arm des zweiten Armsatzes durch eine Durchgangsöffnung der Vorrichtung von einem angrenzenden Arm des zweiten Armsatzes getrennt ist.

7. Vorrichtung nach einem der Ansprüche 3 bis 6, **dadurch gekennzeichnet, dass** das erste und das zweite Glied (2, 3) der Vorrichtung ein allgemein V-förmiges Profil aufweisen, woraus sich ergibt, dass sich jede Nut ihrer Länge nach in einer allgemeinen V-Form erstreckt.

8. Vorrichtung nach Anspruch 3 oder Anspruch 4, **dadurch gekennzeichnet, dass** das erste Glied (2) eine erste und eine zweite und eine dritte Wand (19, 20, 21) umfasst, wobei die erste und die zweite Wand (19, 20) im Wesentlichen parallel zueinander sind und im Wesentlichen senkrecht zur dritten Wand (21) stehen, jede Nut (10) des ersten Gliedes (2) einen in der ersten Wand (19) gebildeten Teil, einen in der zweiten Wand (20) gebildeten Teil, und einen in der dritten Wand (21) gebildeten Teil umfasst, und dadurch, dass das zweite Glied (3) eine Wand (22) umfasst, in der jede Nut (11) des zweiten Gliedes (3) gebildet ist, welche in der zusammengebauten Konfiguration mit einer entsprechenden Nut (10) des ersten Gliedes (2) zusammenwirkt, um eine entsprechende Stelle eines der Halterahmen (4) zu definieren, die dazu bestimmt ist, ein Scheibenpaar aufzunehmen.

9. Vorrichtung nach einem der vorstehenden Ansprüche, **dadurch gekennzeichnet, dass** das erste und das zweite Glied (2, 3) in der zusammengebauten Konfiguration durch gegenseitigen Kontakt zusammengebaut sind, insbesondere so, dass das zweite Glied (3) durch Schwerkraft auf dem ersten Glied (2) ruht.

10. Vorrichtung nach einem der vorstehenden Ansprüche, **dadurch gekennzeichnet, dass** das erste und das zweite Glied (2, 3) aus Quarz bestehen.

11. Vorrichtung nach einem der vorstehenden Ansprüche, **dadurch gekennzeichnet, dass** sie so ausgelegt ist, dass sie zwischen der zusammengebauten Konfiguration und einer geöffneten Konfiguration variieren kann, wobei in der geöffneten Konfiguration das erste Glied (2) in Bezug auf das zweite Glied (3) eine Stellung einnimmt, die sich von der in der zusammengebauten Konfiguration eingenommenen unterscheidet, um das Einsetzen von Scheiben in Halterahmenteile, die im ersten Glied (2) gebildet sind, zu ermöglichen.

## Claims

1. A device (1) for holding plates each including a semiconductor material and each having first and second faces, said device including a first member (2) and a second member (3), and said device including, in an assembly configuration of the device:
- the first member (2) assembled to the second member (3) so as to delimit a plurality of holding frames (4) each defining a location (5) intended for the reception of a pair of plates to be held, whose first faces are directed towards each other, each holding frame (4) being adjacent to at least one other holding frame (4),
- for each pair of adjacent holding frames (4), a passage (6) connecting, between said adjacent holding frames (4), the exterior of the device to a space (7) separating the locations (5) defined by said adjacent holding frames (4), **characterized in that** each holding frame (4) is configured so as to border the periphery of each of the second faces of the plates of a pair of plates when it is held in the location defined by said holding frame (4).

2. The device according to the preceding claim, **characterized in that** each holding frame (4) is arranged at the level of a plane specific thereto, the planes being substantially parallel to each other.

3. The device according to any one of the preceding claims, **characterized in that** the first member (2) includes grooves (10), the second member (3) includes grooves (11), and **in that** each holding frame (4) includes one of the grooves (10) of the first member (2) and one of the grooves (11) of the second member (3), said grooves of each holding frame (4) being intended to hold a pair of corresponding plates in the location (5) defined by said holding frame (4), in the assembly configuration the ends of each groove (10) of the first member (2) are each directed towards a corresponding end of one of the grooves (11) of the second member (3).

4. The device according to claim 3, **characterized in that** each groove (10,11) includes a bottom (10a) and two side walls (10b, 10c) extending from the bottom (10a), the depth of said groove being comprised between 2 mm and 20 mm, and the separation distance of the side walls being comprised between 0.2 mm and 2 mm.

5. The device according to any one of claims 3 to 4, **characterized in that** each of the first and second members (2, 3) includes:
- a first bar (14) and a second bar (15),
- an elongate element (16),
- a first set of arms (17) and a second set of arms (18), each arm (17) of the first set of arms connecting the elongate element (16) to the first bar (14) and each arm (18) of the second set of arms connecting the elongate element (16) to the second bar (15),
and **in that** for each of the first and second members, each groove (10, 11) comprises a first section (T1) formed in the first bar (14), a second section (T2) formed in an arm (17) of the first set of arms, a third section (T3) formed in the elongate element (16), a fourth section formed in an arm (18) of the second set of arms, and a fifth section formed in the second bar (15).

6. The device according to the preceding claim, **characterized in that**, for each of the first and second members (2, 3), each arm of the first set of arms is separated from an adjacent arm of the first set of arms by a through opening of the device, and each arm of the second set of arms is separated from an adjacent arm of the second set of arms by a through opening of the device.

7. The device according to any one of claims 3 to 6, **characterized in that** the first and second members (2, 3) of the device have a profile with a V-like general shape resulting **in that** each groove extends along its length in a V-like general shape.

8. The device according to claim 3 or claim 4, **characterized in that** the first member (2) includes first and second and third walls (19, 20, 21), the first and second walls (19, 20) are substantially parallel to each other and substantially perpendicular to the third wall (21), each groove (10) of said first member (2) includes a portion formed in the first wall (19), a portion formed in the second wall (20) and a portion formed in the third wall (21), and **in that** the second member (3) includes a wall (22) in which is formed each groove (11) of said second member (3) cooperating, in the assembly configuration, with a corresponding groove (10) of the first member (2) to define a location of one of the corresponding holding frames (4) intended to receive a pair of plates.

9. The device according to any one of the preceding claims, **characterized in that**, in the assembly configuration, the first and second members (2, 3) are assembled by contact with each other, notably such that the second member (3) rests by gravity on the first member (2).

10. The device according to any one of the preceding claims, **characterized in that** the first and second members (2, 3) are made of quartz.

11. The device according to any one of the preceding claims, **characterized in that** it is configured to vary between the assembly configuration and an opening configuration, in the opening configuration the first member (2) adopts a position relative to the second member (3) different from that adopted in the assembly configuration so as to enable the insertion of plates in portions of holding frames formed in the first member (2).
